# EUROPÄISCHE PATENTSCHRIFT

(11) **EP 3 466 605 B1**
(45) Veröffentlichungstag und Bekanntmachung des Hinweises auf die Patenterteilung: **21.12.2022**
(21) Anmeldenummer: 17195208.8
(22) Anmeldetag: 06.10.2017
(51) Int. Cl.: B23P 21/00, B65G 1/137, H05K 13/00, H05K 13/06

(54) **VERFAHREN ZUR ANZEIGE VON WERKZEUGEN, BAUTEILEN ODER DGL. AUF EINEM WERKSTATTARBEITSPLATZ**
METHOD FOR DISPLAYING TOOLS, COMPONENTS OR SIMILAR ON A WORKSHOP WORK PLACE
PROCÉDÉ D'AFFICHAGE D'OUTILS, DE COMPOSANTS OU ANALOGUE SUR UN POSTE DE TRAVAIL EN USINE

(43) Veröffentlichungstag der Anmeldung: 10.04.2019
(73) Patentinhaber: Ulixes Robotersysteme GmbH, 70736 Fellbach (DE)
(72) Erfinder: Tillmann, Alexander, 70174 Stuttgart (DE)
(74) Vertreter: Wasmuth, Rolf

(56) Entgegenhaltungen:
- WO-A1-03/033381
- WO-A2-2007/044558
- DE-A1- 2 716 548
- DE-A1- 10 320 557
- DE-U1-202011 106 404

## Beschreibung

Die Erfindung betrifft ein Verfahren zur Unterstützung von an einem Werkstattarbeitsplatz auszuführenden Arbeitsschritten, wobei der Werkstattarbeitsplatz Werkzeuge und/oder Bauteile umfasst. Die von einem Benutzer auszuführenden einzelnen Arbeitsschritte werden von einer zentralen Steuereinheit über eine optische Anzeige angezeigt. Dabei werden die Position der zur Tätigkeit erforderlichen Werkzeuge und/oder Bauteile mit zumindest einem Lichtstrahl angestrahlt und/oder die Position eines zu montierenden Teils angezeigt.

Ein derartiges Verfahren ist aus der DE 103 20 557 B4 bekannt. Die zum Zusammenbau eines Bauteils erforderlichen einzelnen Arbeitsschritte sind in einem elektronischen Speicher abgelegt und werden von einer zentralen Steuereinheit sukzessive ausgelesen und über eine Bilderzeugungseinrichtung auf die Arbeitsfläche des Werkstattarbeitsplatzes oder in der Nähe dieser Arbeitsfläche abgebildet. Damit sieht die Arbeitsperson die einzelnen Arbeitsschritte, z. B. als starre Bilder und kann entsprechend dem jeweiligen Arbeitsschritt die Montage eines Bauteils oder dessen Prüfung vornehmen.

Die DE 27 16 548 A1 zeigt ein Verfahren nach dem Oberbegriff von Anspruch 1 zur Erzeugung einer Bestückungsortanzeige auf einer mit Bauelementen zu bestückenden Trägerplatte, bei dem die Bestückungsorte mittels eines Leuchtpunkts kenntlich gemacht werden.

Die WO 2007/044558 A2 offenbart eine Vorrichtung mit zwei Lichtquellen, von denen Lichtstrahlen zur Beleuchtung von Stellen auf einem Werkstück, an denen Bearbeitungsschritte durchgeführt werden sollen, ausgehen.

Die DE 20 2011 106 404 U1 offenbart einen Montagearbeitsplatz, an dem verschiedene Kleinteileboxen eines Gestells in einer bestimmten Reihenfolge mit einer LED beleuchtet werden.

Die WO 03/033381 A1 offenbart ein Verfahren zur Auswahl eines Produktes aus einem Produktlager, bei dem das Produkt mit einem Lichtstrahl markiert wird.

Insbesondere werden die für die einzelnen Arbeitsschritte erforderlichen Werkzeuge und/oder Bauteile mit einem Lichtstrahl beleuchtet, wodurch der Benutzer angeleitet wird, die jeweiligen Werkzeuge und/oder Bauteile für den nächsten Arbeitsschritt zu verwenden.

Die Arbeitsfläche eines Werkstattarbeitsplatzes ist häufig sehr groß und die Anzeige der erforderlichen Werkzeuge und/oder Bauteile mittels eines Lichtstrahles oder eines Lichtpunktes oft schwer erkennbar. Liegt der Werkstattarbeitsplatz voller Teile und Objekte, muss der Benutzer häufig das anzeigende Lichtsignal suchen, was zu Zeitverzögerungen führt. Ist die Umgebung der Arbeitsfläche darüber hinaus hell, z. B. dem Sonnenlicht ausgesetzt, ist die Beleuchtung der Werkzeuge und/oder Bauteile oft kaum erkennbar. Darüber hinaus können z. B. schwarze Kunststoffteile oder reflektierende metallische Teile die Sichtbarkeit einer Beleuchtung für einen Menschen erheblich erschweren.

Der Erfindung liegt die Aufgabe zugrunde, ein Verfahren der gattungsgemäßen Art derart weiterzubilden, dass der Benutzer auch bei widrigen Umständen am Werkstattarbeitsplatz eine von einem Lichtstrahl angezeigte Position schnell und sicher erkennen kann.

Die Aufgabe wird durch ein Verfahren nach Anspruch 1 gelöst.

Der Werkstattarbeitsplatz kann eine physikalische vorhandene Arbeitsfläche aufweisen, die zugleich als Projektionsfläche genutzt werden kann. Der Werkstattarbeitsplatz kann auch einen Arbeitsraum aufweisen, innerhalb dem ein Mensch arbeitet. So kann der Mensch im Stehen in einem Arbeitsraum an einer Ansammlung von Geräten und Vorrichtungen arbeiten, wobei die einzelnen Arbeitsschritte durch Beleuchten der zu benutzenden Geräte, Vorrichtungen, Werkzeuge und/oder Bauteile angezeigt werden. Insbesondere in einem Arbeitsumfeld ohne eine physikalische Arbeitsfläche und somit ohne Projektionsfläche zum Darstellen von Bildern oder dgl. ist die Erfindung besonders nützlich. Die zu benutzenden Geräte, Vorrichtungen, Werkzeuge und/oder Bauteile können dann direkt beleuchtet oder - z. B. mit einem Pointer - angestrahlt werden. Sofern erforderlich oder gewünscht, können an den zu benutzenden Geräten, Vorrichtungen, Werkzeugen und/oder Bauteilen auch Flächen zum Anstrahlen vorgesehen oder zusätzlich entsprechende Flächen angebracht werden. Auch in einem 3D Arbeitsraum mit einer verwinkelten, komponentenreichen Umgebung helfen dynamische Projektionen, um die Erkennbarkeit durch das menschliche Auge signifikant zu steigern. Durch die Erfindung wird eine computergestützte Erweiterung der Realitätswahrnehmung des Menschen nach Art einer ,Augmented Reality' (erweiterte Realität) geschaffen. Unter erweiterter Realität wird vorliegend die visuelle Darstellung von Informationen verstanden, also die Ergänzung von Bildern mit computergenerierten Zusatzinformationen mittels Einblendung und/oder Überlagerung.

Durch die dynamische Veränderung des Lichtstrahls ist dieser vom Benutzer einfacher zu erkennen; bei einem Positionswechsel des Lichtstrahls von einem ersten angezeigten Objekt auf ein zweites anzuzeigendes Objekt ist eine präzise Erkennung des zweiten Objekts in geringer Zeit sichergestellt. Vorgenommene Projektionen werden durch die erfindungsgemäße Dynamik auch bei schwierigen Umgebungen wie große Arbeitsfläche, schlechte Lichtverhältnisse, unterschiedliche Farben oder auch unterschiedliche Materialien der Bauteile und Werkzeuge für einen Menschen gut sichtbar gemacht. Durch dynamische Lichtstrahlen wird die menschliche Wahrnehmung im Umfeld Arbeitsplatz/Werkzeuge/Bauteile optimiert. Insbesondere ist selbst auf Flächen/Bauteilen/Werkzeugen aus verschiedenen Materialien, in unterschiedlichen Farben oder mit reflektierenden Oberflächen eine rasche Erkennung und Wahrnehmung durch einen Menschen gegeben.

Vorteilhaft wird der Lichtstrahl zumindest für eine vorgegebene Zeitspanne dynamisch verändert. Es kann auch zweckmäßig sein, den Lichtstrahl für die gesamte Zeit einer Anzeige dynamisch zu verändern.

In Weiterbildung der Erfindung kann die dynamische Veränderung des Lichtstrahls dadurch erzeugt werden, dass die Farbe des Lichtstrahls geändert wird, die Helligkeit des Lichtstahls geändert wird und/oder die Frequenz des Lichtstrahls geändert wird. So kann der Lichtstrahl vorteilhaft für eine vorgegebene Zeit z. B. in der Helligkeit pulsieren, wodurch ein einfaches Erkennen durch den Benutzer gegeben ist.

Wird der Lichtstrahl entsprechend einem Blinklicht wiederholt ein- und ausgeschaltet, ist eine Erkennung einer anzuzeigenden Position deutlich erleichtert.

In Abhängigkeit vom Arbeitsumfeld kann es auch vorteilhaft sein, den Lichtstrahl derart auszubilden, dass er insbesondere für eine vorgegebene Zeit vorzugsweise wiederholt seine Farbe ändert. Dadurch können insbesondere Materialien unterschiedlicher Farben leicht erkennbar beleuchtet werden.

Zusätzlich oder alternativ zu den vorstehend angegebenen dynamischen Veränderungen des Lichtstrahls kann auch vorgesehen sein, die Form des im Bereich der zweiten, anzuzeigenden Position auftretenden Lichtstrahls zu verändern. So kann es zweckmäßig sein, die Form wiederholt von einer ersten vorgegebenen Form in eine zweite vorgegebene Form zu ändern. So kann die erste vorgegebene Form z. B. ein Stern und die zweite vorgegebene Form ein Kreis sein. Andere zweckmäßige Formen wie Ellipse, Raute, Dreieck, Mehreck oder dgl. sind vorteilhaft möglich.

In einer einfachen Ausgestaltung der Erfindung wird die Größe des im Bereich der zweiten Position auftreffenden Lichtstrahls verändert, was durch einfache Fokussierung des Lichtstrahls und Defokussierung des Lichtstrahls erreicht werden kann. Dadurch ändert sich die Projektion des Lichtstrahls auf dem Objekt und wird größer und kleiner, was die Aufmerksamkeit des Benutzers auf sich zieht und die Erkennung erleichtert.

Zwischen der ersten Position eines Werkzeugs und/oder Bauteils auf dem Werkstattarbeitsplatz und der zweiten Position eines Werkzeugs und/oder Bauteils auf dem Werkstattarbeitsplatz besteht ein Lageabstand. Es ist vorgesehen, dass der Lichtstrahl von der ersten Position in Richtung auf die zweite Position einen Anzeigeweg ausführt, der größer als der Abstand zwischen der ersten und der zweiten Position ist. Ist der Lichtstrahl während dem Positionswechsel permanent eingeschaltet, wird der Benutzer den Weg von der ersten Position zur zweiten Position nachverfolgen und die zweite Position einfach und rasch erkennen. Vorteilhaft ist hierzu vorgesehen, dass der Anzeigeweg des Lichtstrahls längs einer Kurve verläuft. Insbesondere kann es vorteilhaft sein, den Anzeigeweg des Lichtstrahls längs einer Spirale zu führen, wobei die zweite, anzuzeigende Position im Zentrum der Spirale liegt.

In Weiterbildung der Erfindung kann es vorteilhaft sein, den Lichtstrahl nach dem Positionswechsel von der ersten Position auf die zweite Position in zumindest einer horizontalen Koordinate des Arbeitsplatzes vibrieren zu lassen. So kann der Lichtstrahl z. B. in der - horizontalen - x-Koordinate der Ebene der Arbeitsfläche vibrieren oder auch in der - horizontalen - y-Koordinate der Ebene der Arbeitsfläche vibrieren. Insbesondere kann es vorteilhaft sein, wenn der Lichtstrahl sowohl in der x-Achse als auch in y-Achse der insbesondere horizontalen Ebene der Arbeitsfläche vibriert.

Vorteilhaft kann der Lichtstrahl für eine vorgegebene Zeit als Blitzsignal ausgebildet sein, was auch bei ungünstigen Beleuchtungsverhältnissen durch den Benutzer leicht erkennbar ist.

In Weiterbildung der Erfindung kann ergänzend zu dem Lichtsignal ein Zusatzsignal vorgesehen sein, welches die zweite Position hervorhebt. So kann als Zusatzsignal ein zweites Lichtsignal vorgesehen sein, welches z. B. mit einem Pfeil oder dgl. Hervorhebung auf die zweite, anzuzeigende Position zeigt. Auch kann auch ein akustisches Signal, eine Vibration oder ein allgemeines Lichtsignal den Benutzer auf die zweite Position hinweisen.

In Weiterbildung der Erfindung kann auch vorgesehen sein, die Bewegung der Hand des Benutzers akustisch durch eine sich ändernde Frequenz, einen sich ändernden Ton oder eine andere Taktung anzuzeigen, um den Benutzer darauf hinzuweisen, ob er sich mit der Benutzerhand der erforderlichen zweiten Position nähert oder nicht.

Als besondere Erfindung ist vorgesehen, über eine zentrale Steuereinheit zunächst die Farbe eines anzuzeigenden Bauteils und/oder Werkzeugs zu erkennen. Nach der Erkennung wird durch die Steuereinheit der Lichtstrahl insbesondere in seiner Farbe derart angepasst, dass für die Farbe des Bauteils eine verbesserte Erkennung möglich ist. So kann die Farbe des Lichtstrahls derart gewählt werden, dass ein hoher Kontrast bei Auftreffen auf dem Bauteil und/oder Werkzeug gegeben ist. So kann auch unter schwierigen Anzeigebedingungen eine präzise und schnelle Erkennung durch den Menschen gewährleistet werden. Wird der Lichtstrahl darüber hinaus dynamisch geändert, z. B. in seiner Farbe, in seiner Helligkeit und/oder seiner Frequenz, kann die Erkennbarkeit weiter gesteigert werden.

Weiterbildungen der Erfindung ergeben sich aus den weiteren Ansprüchen und der vorstehenden Beschreibung.

## Patentansprüche

1. Verfahren zur Unterstützung von an einem Werkstattarbeitsplatz auszuführenden Arbeitsschritten, wobei der Werkstattarbeitsplatz Werkzeuge und/oder Bauteile umfasst, bei dem einzelne Arbeitsschritte von einer zentralen Steuereinheit über eine optische Anzeige angezeigt werden, wobei die Position der zur Tätigkeit erforderlichen Werkzeuge und/oder Bauteile mit zumindest einem Lichtstrahl angestrahlt und/oder die Position eines zu montierenden Teils angezeigt wird, wobei bei einem Positionswechsel des Lichtstrahls von einer ersten Position auf eine zweite Position der Lichtstrahl zumindest im Bereich der zweiten Position dynamisch verändert wird,
**dadurch gekennzeichnet, dass** zwischen der ersten Position und der zweiten Position ein Abstand gegeben ist, und dass der Lichtstrahl von der ersten Position in Richtung auf die zweite Position einen Anzeigeweg ausführt, der größer als der Abstand ist.

2. Verfahren nach Anspruch 1,
**dadurch gekennzeichnet, dass** der Lichtstrahl zumindest für eine vorgegebene Zeitspanne dynamisch verändert wird.

3. Verfahren nach Anspruch 1,
**dadurch gekennzeichnet, dass** die Farbe, die Helligkeit und/oder die Frequenz des Lichtstrahls geändert wird.

4. Verfahren nach Anspruch 3,
**dadurch gekennzeichnet, dass** die Helligkeit des Lichtstrahls pulsiert.

5. Verfahren nach Anspruch 3,
**dadurch gekennzeichnet, dass** der Lichtstrahl wiederholt ein- und ausgeschaltet wird.

6. Verfahren nach Anspruch 3,
**dadurch gekennzeichnet, dass** der Lichtstrahl wiederholt seine Farbe wechselt.

7. Verfahren nach Anspruch 1,
**dadurch gekennzeichnet, dass** die Form des im Bereich der zweiten Position auftreffenden Lichtstrahls verändert wird.

8. Verfahren nach Anspruch 7,
**dadurch gekennzeichnet, dass** die Form wiederholt von einer ersten vorgegebenen Form in eine zweite vorgegebene Form wechselt.

9. Verfahren nach Anspruch 1,
**dadurch gekennzeichnet, dass** die Größe des im Bereich der zweiten Position auftreffenden Lichtstrahls verändert wird.

10. Verfahren nach Anspruch 1,
**dadurch gekennzeichnet, dass** der Anzeigeweg längs einer Kurve verläuft.

11. Verfahren nach Anspruch 1,
**dadurch gekennzeichnet, dass** der Anzeigeweg längs einer Spirale verläuft.

12. Verfahren nach Anspruch 1,
**dadurch gekennzeichnet, dass** der Lichtstrahl im Bereich der zweiten Position in zumindest einer Raumkoordinate vibriert.

13. Verfahren nach Anspruch 1,
**dadurch gekennzeichnet, dass** der Lichtstrahl für eine vorgegebene Zeit ein Blitzsignal ist.

14. Verfahren nach Anspruch 1,
**dadurch gekennzeichnet, dass** ergänzend zu dem Lichtsignal ein Zusatzsignal vorgesehen ist, welches die zweite Position hervorhebt.

## Claims

1. Method for assisting with work steps to be performed at a workshop workstation, wherein the workshop workstation comprises tools and/or components, in which individual work steps are indicated by a central control unit via a visual indication, wherein the position of the tools and/or components necessary for the actions is irradiated with at least one light beam and/or the position of a part to be assembled is indicated, wherein for a position change of the light beam from a first position to a second position, the light beam is dynamically changed at least in the region of the second position, **characterized in that** there is a distance between the first position and the second position and **in that** the light beam realizes, from the first position in the direction towards the second position, an indication path that is greater than the distance.

2. Method according to claim 1,
**characterized in that** the light beam is dynamically changed at least for a specified period of time.

3. Method according to claim 1,
**characterized in that** the colour, the brightness and/or the frequency of the light beam is changed.

4. Method according to claim 3,
**characterized in that** the brightness of the light beam pulses.

5. Method according to claim 3,
**characterized in that** the light beam is repeatedly switched on and off.

6. Method according to claim 3,
**characterized in that** the light beam repeatedly changes its colour.

7. Method according to claim 1,
**characterized in that** the shape of the light beam that is incident in the region of the second position is changed.

8. Method according to claim 7,
**characterized in that** the shape repeatedly changes from a first specified shape to a second specified shape.

9. Method according to claim 1,
**characterized in that** the size of the light beam that is incident in the region of the second position is changed.

10. Method according to claim 1,
**characterized in that** the indication path extends along a curve.

11. Method according to claim 1,
**characterized in that** the indication path extends along a spiral.

12. Method according to claim 1,
**characterized in that** the light beam vibrates in the region of the second position in at least one spatial coordinate.

13. Method according to claim 1,
**characterized in that** the light beam is a flash signal for a specified period of time.

14. Method according to claim 1,
**characterized in that**, in addition to the light signal, an additional signal is provided which makes the second position stand out.

## Revendications

1. Procédé permettant d'assister des étapes de travail à effectuer à un poste de travail d'atelier, le poste de travail d'atelier comprenant des outils et/ou des composants, dans lequel des étapes de travail individuelles sont indiquées par une unité de commande centrale par l'intermédiaire d'une indication optique, dans lequel la position des outils et/ou composants nécessaires à l'activité est illuminée par au moins un faisceau lumineux et/ou la position d'une pièce à assembler est indiquée, dans lequel, en cas de changement de position du faisceau lumineux d'une première position à une deuxième position, le faisceau lumineux est modifié dynamiquement au moins dans la zone de la deuxième position,
**caractérisé en ce qu'**une distance existe entre la première position et la deuxième position, et **en ce que** le faisceau lumineux parcourt de la première position en direction de la deuxième position un chemin d'indication qui est supérieur à la distance.

2. Procédé selon la revendication 1,
**caractérisé en ce que** le faisceau lumineux est modifié dynamiquement au moins pendant une période de temps prédéfinie.

3. Procédé selon la revendication 1,
**caractérisé en ce que** la couleur, la luminosité et/ou la fréquence du faisceau lumineux sont modifiées.

4. Procédé selon la revendication 3,
**caractérisé en ce que** la luminosité du faisceau lumineux est pulsée.

5. Procédé selon la revendication 3,
**caractérisé en ce que** le faisceau lumineux est allumé et éteint à plusieurs reprises.

6. Procédé selon la revendication 3,
**caractérisé en ce que** le faisceau lumineux change de couleur à plusieurs reprises.

7. Procédé selon la revendication 1,
**caractérisé en ce que** la forme du faisceau lumineux incident dans la zone de la deuxième position est modifiée.

8. Procédé selon la revendication 7,
**caractérisé en ce que** la forme change à plusieurs reprises d'une première forme prédéfinie à une deuxième forme prédéfinie.

9. Procédé selon la revendication 1,
**caractérisé en ce que** la dimension du faisceau lumineux incident dans la zone de la deuxième position est modifiée.

10. Procédé selon la revendication 1,
**caractérisé en ce que** le chemin d'indication s'étend le long d'une courbe.

11. Procédé selon la revendication 1,
**caractérisé en ce que** le chemin d'indication s'étend le long d'une spirale.

12. Procédé selon la revendication 1,
**caractérisé en ce que** le faisceau lumineux vibre au niveau d'au moins une coordonnée spatiale dans la zone de la deuxième position.

13. Procédé selon la revendication 1,
**caractérisé en ce que** le faisceau lumineux est un signal flash pendant un délai prédéfini.

14. Procédé selon la revendication 1,
**caractérisé en ce qu'**en complément au signal lumineux, un signal supplémentaire est prévu qui met en évidence la deuxième position.
